# EUROPEAN PATENT SPECIFICATION

(11) **EP 2 883 922 B1**
(45) Date of publication and mention of the grant of the patent: **10.01.2018**
(21) Application number: 14195021.2
(22) Date of filing: 26.11.2014
(51) Int. Cl.: C09D 11/52, H05K 1/09, B82B 3/00, C09D 11/322, H01B 1/02, H05K 1/03

(54) **Metal nanoparticle synthesis and conductive ink formulation**
Metallnanoteilchensynthese und leitfähige Tintenformulierung
Synthèse de nanoparticules métalliques et formulation d'encre conductrice

(30) Priority: 16.12.2013 US 201361963847 P
(43) Date of publication of application: 17.06.2015
(73) Proprietor: Nano and Advanced Materials Institute Limited, Hong Kong (CN)
(72) Inventor: Fu, Li, New Territories (CN); Li, Kai, New Territories (CN); Li, Chau Shek, New Territories (CN)
(74) Representative: Chaillot, Geneviève

(56) References cited:
- WO-A1-2012/171936
- WO-A2-2009/111393
- KR-A- 20110 125 145
- US-A1- 2007 056 402
- US-A1- 2007 275 259
- US-A1- 2008 157 029
- US-A1- 2008 241 391
- US-A1- 2008 241 414
- US-A1- 2009 053 525

## Description

### FIELD OF INVENTION

This invention relates to an inkjet ink formulation, and in particular an ink formulation with metal nanoparticles.

### BACKGROUND OF INVENTION

Metal nanoparticles and its related ink have attracted broad interest in printed electronics industry due to their unique properties related with the reduced size and increased surface area. More recently, metal nanoparticle inks has been used to directly print fine conductive patterns with inkjet printing method. This particular method requires that the ink contains high concentration of small nanoparticles which can be well dispersed in solvents. For example, WO 2009/111393 discusses a conductive ink that includes metallic nanoparticles, a polymeric dispersant and a solvent, and further discloses that the metallic nanoparticles include about 10 wt% to about 60 wt% of the ink.

Even though there are lots of research in this area, the synthesis process of metal nanoparticles and the stability of the formulated still have room for improvement. The printed film requires sintering at higher temperature to achieve good conductivity of the printed patterns. It is desirable to have low sintering temperature so that the device fabrication process is compatible with plastic substrate used for many flexible electronics.

### SUMMARY OF INVENTION

In the light of the foregoing background, it is an object of the present invention to provide an improved metal nanoparticle synthesis method and an ink formulation with high solid material loading and to be stable over its shelf life as well as to be able to form ink formulation with good conductivity after low temperature annealing.

Accordingly, the present invention, in one aspect, provides an ink formulation, comprising metal nanoparticles in the range of 10%-40% by weight-volume percentage of said ink formulation; a dispersant in the range of 0.5%-5% by weight percentage of said ink formulation; a viscosity modifying solvent in the range of 15%-50% by weight percentage of said ink formulation; and a surface tension adjusting solvent in the range of 30%-80% by weight percentage of said ink formulation.

In one exemplary embodiment of the present invention, the size of the metal nanoparticles is 20-30 nanometers.

In one exemplary embodiment of the present invention, the viscosity of the ink composition is between 3-30cPs, or 3-20cPs.

In another aspect, the present invention discloses a method of forming a metal nanoparticle mixture, comprising
a) dissolving PVP in glycol based solvent to obtain PVP solution;
b) dissolving metal precursor into a hydrophilic solvent to prepare metal salt solution;
c) adding said metal salt solution in step b) into said PVP solution in step a) with controlled speed to formulate a mixture; and
d) centrifuging said mixture in step c) and further washing to obtain said metal nanoparticle.

In one exemplary embodiment of the present invention, the size of said metal nanoparticles is in the range of 20-30 nanometers.

In one exemplary embodiment of the present invention, a reducing agent is further introduced before the above step c) into the PVP solution in the above step a).

In a further aspect, the present invention provides a method of fabricating a conductive film comprsing
a) forming an ink formulation of claim 1;
b) filtering said ink formulation in step a) and loading the filtered ink into a printer;
c) forming a film by printing said filtered ink on a substrate by pre-set printing parameters; and
d) sintering said film in step c) to obtain said conductive film;
wherein the sintering is conducted at a temperature not higher than 150°C.

In one exemplary embodiment of the present invention, the resistivity of said conductive film is less than 15µΩ.cm, or less than 12µΩ.cm.

One of the advantages of the present invention is the high stability of the ink formulation. Another advantage of the present invention is that the wetting property and jetting performance of the ink formuation have been improved while the loading of the metal nanoparticles can be maintained at a high concentration. In addition, according to the present invention, a film with good conductivity can be formed at a lower sintering temperature.

### BRIEF DESCRIPTION OF FIGURES

Fig. 1 shows TEM image of Ag nanoparticle synthesized in example 1 of the invention.
Fig. 2 shows SEM image of Cu nanoparticles synthesized in example 2 of the invention.
Fig. 3(a) shows SEM image of a deposited film comprising Ag nanoparticle; Fig. 3(b) shows SEM image of the film after annealing at 150°C for 30 min.

### DETAILED DESCRIPTION OF THE PREFERRED EMBODIMENTS

As used herein and in the claims, "comprising" means including the following elements but not excluding others.

Fluent drop formation refers to the relatively constant drop velocity of the ink from the nozzle while the drop shape is ideally tear-shaped sphere without tail. The drop flows along the co-axial of the nozzle without tilting.

### Synthesis and analysis of a metal nanoparticle mixture

The present invention provides a facile method to synthesis metal nanoparticles that can be dispersed in aqueous solvents:
1. Dissolve polyvinvylpyrrolidone (PVP) in ethylene glycol (EG) or diethylene glycol (DEG) by heating up to 90-160°C with mechanical agitation.
2. Add reducing agent to the above PVP solution if it is required. The need of reducing agent and its concentration will depends on the metal salt used.
3. Dissolve metal precursor into DI water or EG solution.
4. Add metal salt solution into PVP solution with controlled speed.
5. Separate metal nanoparticles from solution by centrifugation after the reactions are completed.
6. Purify the nanoparticles by washing with acetone/alchol solvents and separate by centrifugation.

The images of the metal nanoparticles are captured by TEM or SEM. The size of the metal nanoparticles is in the range of 20nm-30nm.

### Synthesis of ink formulation

The present invention provides a method to prepare ink formulation comprising at least one metal nanoparticles:
1. The as-washed metallic nanoparticles and solvent are mixed thoroughly by a mild energy mixer such as planetary ultrasonic mixer until well combined, to form wet slurry.
2. A pre-mixed stable solvent is also formulated by mixing proper weight part of dispersant, solvent etc., through a general mechanical agitator or ultrasonic mixer.
3. The metal nanoparticles slurry and pre-mixed solvent are weighed according to suitable weight ratio, and then they are mixed and formulated into ink through dispersion process that combines medium/high energy mixer and mechanical agitation.
4. The resulted ink is filtered through a 0.45 micron filter, such as those manufactured by Millipore, USA. It is loaded into a piezo-electrical inkjet printer cartridge and serial printing parameters are adjusted, until stable formation and jetting of ink drop.

The ink formulation is further filtered and loaded into a printer. The desired patterns can be obtained by proper programming the printing parameters.

### Composition of the ink formulation

The ink formulation should contain at least one metal nanoparticle contributing to the conductivity of the ink formulation.

The ink formulation can contain a dispersant functionalized with specific groups having affinity to nanoparticles, in order to facilitate nanoparticles dispersion and prevent agglomeration for stable jetting.

One or more viscosity modifying solvent can be added in the ink to adust the viscosity of the ink formulation to a range for smooth printing.

The surface tension can be tuned until fluent drop formation from the printer to improve jetting performance and wetting property of the ink formulation.

### Example 1 Synthesis of silver nanoparticle

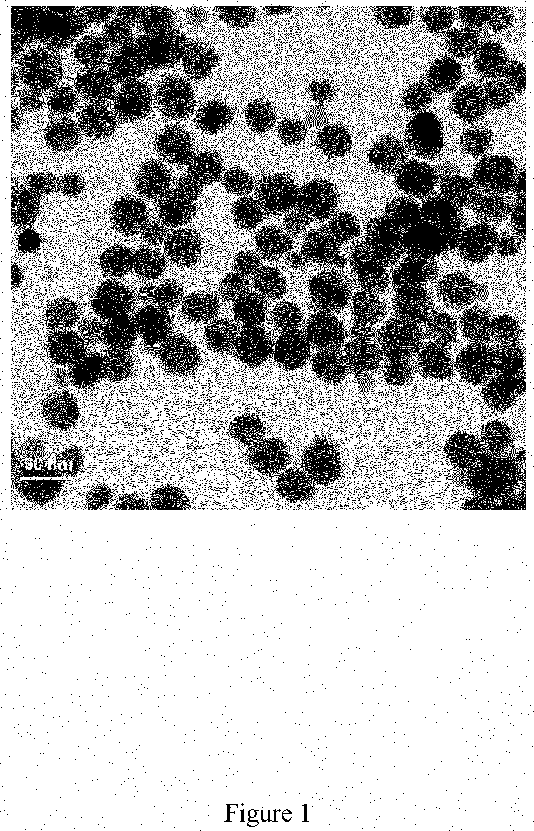

36.4g of polyvinvylpyrrolidone (Mw: 10000) was dissolved into 75mL of ethylene glycol with magnetic stirring while heated to 120°C 5.8g of silver nitrate was dissolved into 25 mL of ethylene glycol. The silver nitrate solution was added into PVP solution and the reaction mixture was stirred for 1hour before cooling down to room temperature. After completion of the reaction, the mixture was centrifuged out at 10000rpm and washed with ethanol and acetone. The purified silver nanoparticles were not dried, but kept in ethanol environment for subsequent ink formulation. Please refer to Fig. 1 for the TEM image of Ag nanoparticles as synthesized.

### Example 2 Synthesis of copper nanoparticle

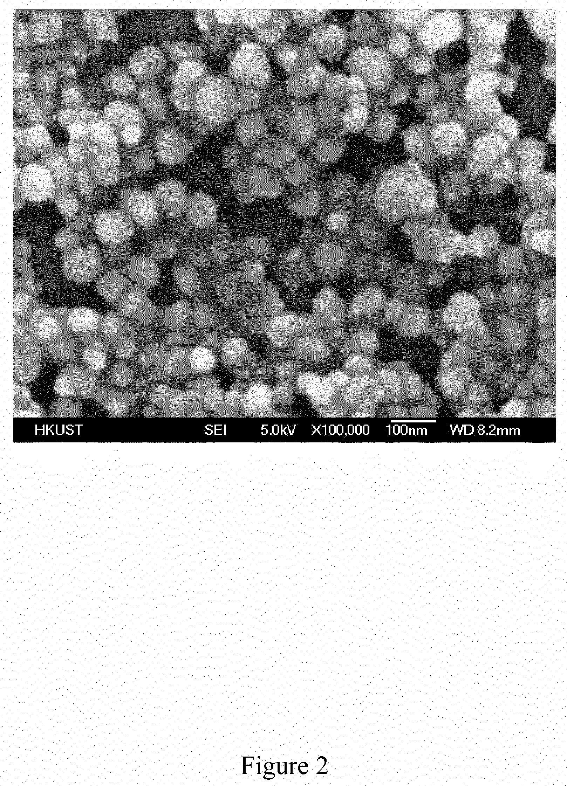

37g PVP (Mw: 40000) and 1.1g sodium hypophosphate (NaH2PO2) was dissolved into 100ml of diethylene glycol (DEG) with magnetic stirring while heated to 140°C. 1.6g copper sulfate (CuSO4) was dissolved into 10ml DI water or EG. The copper sulfate solution was injected into the PVP solution with a controlled speed of 10ml/min and the reaction mixture was stirred for 1hour. After completion of the reaction, the mixture was centrifuged out at 10000rpm and washed with ethanol and acetone. The purified copper nanoparticles were not dried, but kept in ethanol environment for subsequent ink formulation. Please refer to Fig. 2 for the SEM image of Cu nanoparticles as synthesized.

### Example 3 Preparation of silver nanoparticle ink formulation

Mix 5 mL of H2O, 2.5 mL of EG, 2 mL of IPA, 0.5 mL of glycerol and 0.1 g of DISPERBYK-190 into a 20-mL glass vial and mix the solutions with vortex. Add 3.1g of silver nanoparticle from example 1 into the solution mixture. Disperse the nanoparticles through mechanical stirring in an ultrasonic bath for >3 hours. 10ml of ink with solid loading of ∼3g/10ml can be obtained at the end. The resultant ink formulation can be stable for at least 3-6 months. The jetting performance and wetting property thereof have been improved. The ink can drop at a relatively constant velocity from the nozzle while the drop shape is tear-shaped sphere without tail. The drop flows along the co-axial of the nozzle without tilting.

### Example 4 Preparation of copper nanoparticle ink formulation

Mix 5 mL of H2O, 2.5 mL of EG, 2 mL of IPA, 0.5 mL of glycerol and 0.1 g of DISPERBYK-190 into a 20-mL glass vial and mix the solutions with vortex. Add 1.5g of copper nanoparticle from example 2 into the solution mixture. Disperse the nanoparticles through mechanical stirring in an ultrasonic bath for >3 hours. 10ml of ink with solid loading of ∼1.5g/10ml can be obtained at the end. The resultant ink formulation can be stable for at least 3-6 months. The jetting performance and wetting property thereof have been improved. The ink can drop at a relatively constant velocity from the nozzle while the drop shape is tear-shaped sphere without tail. The drop flows along the co-axial of the nozzle without tilting.

### Example 5 Preparation of silver-copper nanoparticle ink formulation

Mix 5 mL of H2O, 2.5 mL of EG, 2 mL of IPA, 0.5 mL of glycerol and 0.1 g of DISPERBYK-190 into a 20-mL glass vial and mix the solutions with vortex. Add 1.5g of copper nanoparticle and 1g of silver nanoparticle into the solution mixture. Disperse the nanoparticles through mechanical stirring in an ultrasonic bath for >3 hours. 10ml of ink with solid loading of ∼2.5g/10ml can be obtained at the end. The resultant ink formulation can be stable for at least 3-6 months. The jetting performance and wetting property thereof have been improved. The ink can drop at a relatively constant velocity from the nozzle while the drop shape is tear-shaped sphere without tail. The drop flows along the co-axial of the nozzle without tilting.

### Example 6 Preparation of printed film and post sintering process

The ink formulation is filtered and loaded into a printer. The desired patterns can be obtained by proper programming the printing parameters.

The printed patterns can be electrically conductive shortly after sintered. Apattern with size of 3mmx5mm with film thickness of 900nm has been printed with the ink from example 1 by inkjet printer. After thermal annealing at 150°C for 30min, a specific resistivity of <12µΩ.cm has been achieved.

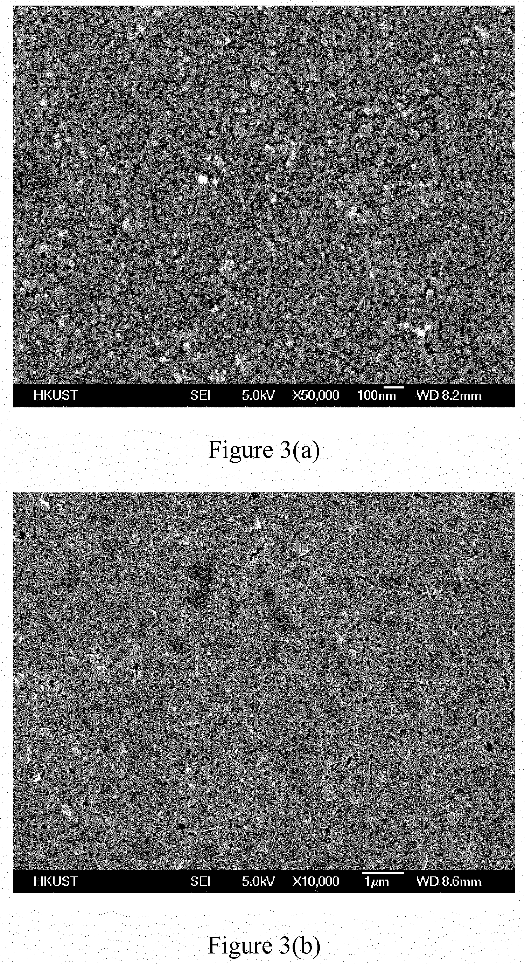

Referring now to Fig. 3, it can be seen from the SEM image that the grain size has been significantly increased (Fig. 3b) after annealing at 150°C for 30 min compared with that in the deposited film (Fi. 3(a)), which indicates the formation of patterns with high conductivity. For instance, the grain size can reach to 0.5µm -1.0µm after sintering at 150 °C.

The thickness of the resultant film is in the range of 0.75µm-1.0µm while the resistance ranges from 0.1-0.3ohm/sq.

The exemplary embodiments of the present invention are thus fully described. Although the description referred to particular embodiments, it will be clear to one skilled in the art that the present invention may be practiced with variation of these specific details. Hence this invention should not be construed as limited to the embodiments set forth herein.

For example, the metal nanoparticles, contributing to the conductivity of the ink, may include, but not limited to gold, silver, copper, nickel, cobalt, zinc and other metals being electrically conductive. More than one type of metallic nanoparticles can be introduced into the ink. In the above embodiment of the present invention, the metal nanoparticles are silver nanoparticles, copper nanoparticles or combined copper and silver nanoparticles.

The dispersant may include, but not limited to BYK-108, BYK-110, BYK-180, BYK-190, BYK-333, provided by BYK Additives & Instruments, Germany. In one embodiment, the dispersant is BYK-190, an aqueous solution containing high molecular weight block copolymer.

The viscosity modifying solvent may include, but not limited to glycol-based compound such as ethylene glycol, diethylene glycol, triethylene glycol, glycerol, propylene glycol, polyethylene glycol, dipropylene glycol, triethylene glycol butyl ether and triethylene glycol methyl ether etc. In one embodiment of the invention, ethylene glycol and glycerol together are used to adjust the ink viscosity.

The surface tension adjusting solvent may include, but not limited to a hydrophilic solvent, such as water, methanol, ethanol, propanol, isopropanol, ethylene glycol, diethylene glycol, 1-butanol, 2-butanol, 2-methoxyethanol etc. The surface tension of the ink formulation should be adjusted between 30 and 40dyen/cm.

The surface tension adjusting solvent is in the range of 30%-80% by weight percentage of the ink formulation, preferably in the range of 35%-60% or 55%-80%, or 70%-80%; the viscosity modifying solvent is in the range of 15%-50% by weight percentage of the ink formulation, preferably in the range of 15%-25% or 18%-33%, or 23%-28%; the dispersant is in the range of 0.5%-5% by weight percentage of the ink formulation, preferably 2.5%; the metal nanoparticle is in the range of 10%-40% by weight-volume percentage of the ink formulation, preferably 30%.

The metal precursor may include but not limited to metal chloride, metal nitrate, metal sulfate and metal acetate.

The controlled speed for adding metal solution into PVP solution depends on the characteristics of the metal precursors and the concentration thereof. It may be instantaneous, which means that the metal solution is poured in all together, or in the range of 1-10ml/min, or 1-3ml/min.

The reducing agent may include but not limited to sodium hypophosphate, ascorbic acid, sodium borohydride and hydrazine.

The sintering can be performed through a thermal oven or high energy flashing lamp.

The printer in the present invention can be a piezo-electrical inkjet or office-format printer.

The printed substrate may include, but not limited to standard office paper, photo paper, flexible thermoplastics, such as polyethylene terephthalate (PET), polybutylene terephthalate (PBT), polyethylene naphthalate (PEN), polypolyimide (PI) etc, and rigid substrate like glass slide.

Unless defined otherwise, all technical and scientific terms used herein have the same meaning as commonly understood by one of ordinary skill in the art to which this invention belongs.

The scope of the invention is defined solely by the appended claims.

## Claims

1. An ink formulation, comprising:
2.5 ml ethylene glycol;
2 ml isopropanol (IPA);
0.5 ml glycerol;
5 ml water;
0.1 g DISPERBYK-190;
1 g silver nanoparticles in ethanol; and
1.5 g copper nanoparticles in ethanol,
wherein the ink formulation has a solid loading of 2.5g/10ml, and the silver nanoparticles in ethanol are produced by a method that includes steps of:
dissolving 36.4 g of polyvinylpyrrolidone with molecular weight of 10000 into 75 ml of ethylene glycol with magnetic stirring while heated to 120°C to obtain a polyvinylpyrrolidone solution;
dissolving 5.8g of silver nitrate into 25ml of ethylene glycol to obtain a silver nitrate solution;
adding the silver nitrate solution into the polyvinylpyrrolidone solution and stirring for 1 hour to obtain a reaction mixture of silver nitrate and polyvinylpyrrolidone;
cooling down the reaction mixture of silver nitrate and polyvinylpyrrolidone to room temperature;
centrifuging the reaction mixture of silver nitrate and polyvinylpyrrolidone at 10000 rpm to obtain a centrifuged reaction mixture of silver nitrate and polyvinylpyrrolidone;
washing the centrifuged reaction mixture of silver nitrate and polyvinylpyrrolidone with ethanol and acetone to obtain purified silver nanoparticles; and
keeping the silver nanoparticles in ethanol,
wherein the copper nanoparticles in ethanol are produced by a method that includes steps of:
dissolving 37 g of polyvinylpyrrolidone with molecular weight of 40000 and 1.1 g of sodium hypophosphate into 100 ml diethylene glycol with magnetic stirring while heated to 140°C to obtain a Polyvinylpyrrolidone solution;
dissolving 1.6 g of copper sulfate into 10 ml DI water or ethylene glycol to obtain a copper sulfate solution;
injecting the copper sulfate solution into the polyvinylpyrrolidone solution at a controlled speed of 10 ml/min and stirring for 1 hour to obtain a reaction mixture of copper sulfate and polyvinylpyrrolidone centrifuging the reaction mixture of copper sulfate and polyvinylpyrrolidone at 10000 rpm to obtain a centrifuged reaction mixture of copper sulfate and polyvinylpyrrolidone washing the centrifuged reaction mixture of copper sulfate and polyvinylpyrrolidone with ethanol and acetone to obtain purified copper nanoparticles; and keeping the copper nanoparticles in ethanol.

2. An ink formulation, comprising:
2.5 ml ethylene glycol;
2 ml isopropanol (IPA);
0.5 ml glycerol;
5 ml water;
0.1 g DISPERBYK-190; and
3.1 g silver nanoparticles in ethanol,
wherein the ink formulation has a solid loading of 3g/10ml; and the silver nanoparticles in ethanol are produced by a method that includes steps of:
dissolving 36.4 g of polyvinylpyrrolidone with molecular weight of 10000 into 75 ml of ethylene glycol with magnetic stirring while heated to 120°C to obtain a polyvinylpyrrolidone solution;
dissolving 5.8 g of silver nitrate into 25 ml of ethylene glycol to obtain a silver nitrate solution;
adding the silver nitrate solution into the polyvinylpyrrolidone solution and stirring for 1 hour to obtain a reaction mixture;
cooling down the reaction mixture to room temperature;
centrifuging the reaction mixture at 10000 rpm to obtain a centrifuged reaction mixture;
washing the centrifuged reaction mixture with ethanol and acetone to obtain purified silver nanoparticles; and
keeping the silver nanoparticles in ethanol.

3. An ink formulation, comprising:
2.5 ml ethylene glycol;
2 ml isopropanol (IPA);
0.5 ml glycerol;
5 ml water;
0.1 g DISPERBYK-190; and
1.5 g copper nanoparticles in ethanol,
wherein the ink formulation has a solid loading of 1.5g/10ml, and the copper nanoparticles in ethanol are produced by a method that includes steps of:
dissolving 37 g of polyvinylpyrrolidone with molecular weight of 40000 and 1.1 g of sodium hypophosphate into 100 ml diethylene glycol with magnetic stirring while heated to 140°C to obtain a polyvinylpyrrolidone solution;
dissolving 1.6 g of copper sulfate into 10 ml DI water or ethylene glycol to obtain a copper sulfate solution;
injecting the copper sulfate solution into the polyvinylpyrrolidone solution at a controlled speed of 10 ml/min and stirring for 1 hour to obtain a reaction mixture;
centrifuging the reaction mixture at 10000 rpm to obtain a centrifuged reaction mixture;
washing the centrifuged reaction mixture with ethanol and acetone to obtain purified copper nanoparticles; and
keeping the copper nanoparticles in ethanol.

4. A method of fabricating a conductive film, comprising:
a. preparing the ink formulation of claim 1, comprising:
1) preparing the silver nanoparticles in ethanol, comprising:
dissolving 36.4 g of polyvinylpyrrolidone with molecular weight of 10000 into 75 ml of ethylene glycol with magnetic stirring while heated to 120°C to obtain a polyvinylpyrrolidone solution;
dissolving 5.8g of silver nitrate into 25ml of ethylene glycol to obtain a silver nitrate solution;
adding the silver nitrate solution into the polyvinylpyrrolidone solution and stirring for 1 hour to obtain a reaction mixture of silver nitrate and polyvinylpyrrolidone
cooling down the reaction mixture to room temperature;
centrifuging the reaction mixture of silver nitrate and polyvinylpyrrolidone at 10000 rpm to obtain a centrifuged reaction mixture of silver nitrate and polyvinylpyrrolidone
washing the centrifuged reaction mixture of silver nitrate and polyvinylpyrrolidone with ethanol and acetone to obtain purified silver nanoparticles;
keeping the silver nanoparticles in ethanol;
2) preparing the copper nanoparticles in ethanol, comprising:
dissolving 37 g of polyvinylpyrrolidone with molecular weight of 40000 and 1.1 g of sodium hypophosphate into 100 ml diethylene glycol with magnetic stirring while heated to 140°C to obtain a polyvinylpyrrolidone solution;
dissolving 1.6 g of copper sulfate into 10 ml DI water or ethylene glycol to obtain a copper sulfate solution;
injecting the copper sulfate solution into the polyvinylpyrrolidone solution at a controlled speed of 10 ml/min and stirring for 1 hour to obtain a reaction mixture of copper sulfate and polyvinylpyrrolidone
centrifuging the reaction mixture of copper sulfate and polyvinylpyrrolidone at 10000 rpm to obtain a centrifuged reaction mixture of copper sulfate and polyvinylpyrrolidone;
washing the centrifuged reaction mixture of copper sulfate and polyvinylpyrrolidone with ethanol and acetone to obtain purified copper nanoparticles;
keeping the copper nanoparticles in ethanol;
3) mixing 5ml of water, 2.5ml of ethylene glycol, 2ml of isopropanol (IPA), 0.5ml of glycerol, 0.1g of DISPERBYK-190 to obtain a solution mixture; and
4) adding 1g of the silver nanoparticles in ethanol and 1.5g of the copper nanoparticles in ethanol into the solution mixture;
5) dispersing the silver nanoparticles in ethanol and the copper nanoparticles in ethanol in the solution mixture by mechanical stirring in an ultrasonic bath for more than 3 hours to obtain the ink formulation, wherein the ink formulation has a solid loading of 2.5g/10ml;
b. filtering the ink formulation and loading the ink formulation into a printer; and
c. obtaining the conductive film by printing the ink formulation from the printer to form a film and sintering the film at 150°C for 30 min.

5. A method of fabricating a conductive film, comprising:
a. preparing the ink formulation of claim 2, comprising:
dissolving 36.4g of polyvinylpyrrolidone with molecular weight of 10000 into 75ml of ethylene glycol with magnetic stirring while heated to 120°C to obtain a polyvinylpyrrolidone solution;
dissolving 5.8g of silver nitrate into 25ml of ethylene glycol to obtain a silver nitrate solution;
adding the silver nitrate solution into the polyvinylpyrrolidone solution and stirring for 1 hour to obtain a reaction mixture;
cooling down the reaction mixture to room temperature;
centrifuging the reaction mixture at 10000 rpm to obtain a centrifuged reaction mixture;
washing the centrifuged reaction mixture with ethanol and acetone to obtain purified silver nanoparticles;
keeping the silver nanoparticles in ethanol;
mixing 5ml of water, 2.5ml of ethylene glycol, 2ml of isopropanol (IPA), 0.5ml of glycerol, 0.1g of DISPERBYK-190 to obtain a solution mixture; and
adding 3.1g of the silver nanoparticles in ethanol into the solution mixture;
dispersing the silver nanoparticles in ethanol by mechanical stirring in an ultrasonic bath for more than 3 hours to obtain the ink formulation, wherein the ink formulation has a solid loading of 3g/10ml;
b. filtering the ink formulation and loading the ink formulation into a printer; and
c. obtaining the conductive film by printing the ink formulation from the printer to form a film and sintering the film at 150 °C for 30 min.

6. A method of fabricating a conductive film, comprising:
a. preparing the ink formulation of claim 3, comprising:
dissolving 37g of polyvinylpyrrolidone with molecular weight of 40000 and 1.1g of sodium hypophosphate into 100ml of diethylene glycol with magnetic stirring while heated to 140°C to obtain a polyvinylpyrrolidone solution;
dissolving 1.6g of copper sulfate into 10ml DI water or ethylene glycol to obtain a copper sulfate solution;
injecting the copper sulfate solution into the polyvinylpyrrolidone solution at a controlled speed of 10 ml/min and stirring for 1 hour to obtain a reaction mixture;
centrifuging the reaction mixture at 10000 rpm to obtain a centrifuged reaction mixture;
washing the centrifuged reaction mixture with ethanol and acetone to obtain purified copper nanoparticles;
keeping the copper nanoparticles in ethanol;
mixing 5ml of water, 2.5ml of ethylene glycol, 2ml of isopropanol (IPA), 0.5ml of glycerol, 0.1g of DISPERBYK-190 to obtain a solution mixture; and
adding 1.5g of the copper nanoparticles in ethanol into the solution mixture;
dispersing the copper nanoparticles in ethanol by mechanical stirring in an ultrasonic bath for more than 3 hours to obtain the ink formulation, wherein the ink formulation has a solid loading of 1.5g/10ml;
b. filtering the ink formulation and loading the ink formulation into a printer;
c. obtaining the conductive film by printing the ink formulation from the printer to form a film and sintering the film at 150°C for 30 min.

7. The method of claim 4, 5 or 6, wherein a resistivity of the conductive film is less than 15 µΩ.cm.

8. The method of claims 4, 5 or 6, wherein a resistivity of the conductive film is less than 12 µΩ.cm.

9. The method of claims 4, 5 or 6, wherein a thickness of the conductive film is in a range of 0.75 µm - 1.0 µm.

10. The method of claims 4, 5 or 6, wherein a pattern with a size of 3 mm x 5 mm is printed to form the conductive film, a grain size of the conductive film is 0.5 µm
- 1.0 µm after sintering at 150°C, the conductive film has a thickness of 0.75 µm
- 1.0 µm and a resistance of the conductive film is in a range of 0.1-0.3ohm/sq.

11. The method of claims 4, 5 or 6, wherein the conductive film is printed onto a substrate, and the substrate is selected from a group consisting of standard office paper, photo paper, polyethylene terephthalate, polybutylene terephthalate, polyethylene naphthalate, polyimide and glass.

12. The method of claims 4, 5 or 6, wherein the sintering of the film is performed through a thermal oven or a high energy flashing lamp.

## Patentansprüche

1. - Tintenformulierung mit:
2.5 ml Äthylenglykol;
2 ml Isopropanol (IPA);
0.5 ml Glycerol;
5 ml Wasser;
0.1 g DISPERBYK-190;
1 g Silbernanopartikel in Ethanol; und
1.5 g Kupfernanopartikel in Ethanol,
wobei die Tintenformulierung einen Feststoffanteil von 2,5g/10ml hat und die Silbernanopartikel in Ethanol durch eine Methode mit folgenden Phasen hergestellt werden:
Auflösen von 36.4 g Polyvinylpyrrolidon mit Molekularmasse 10000 in 75 ml Äthylenglykol mit magnetischer Rührung während der Erhitzung auf 120°C, um eine Polyvinylpyrrolidonlösung zu erhalten;
Auflösen von 5.8g Silbernitrat in 25ml Äthylenglykol, um eine Silbernitratlösung zu erhalten;
Hinzufügen der Silbernitratlösung zur Polyvinylpyrrolidonlösung und Rühren 1 Stunde lang,um eine Reaktionsmischung von Silbernitrat und Polyvinylpyrrolidon zu erhalten;
Abkühlung der Reaktionsmischung von Silbernitrat und Polyvinylpyrrolidon auf Raumtemperatur;
Zentrifugieren der Reaktionsmischung von Silbernitrat und Polyvinylpyrrolidon bei 10000 U/Min, um eine zentrifugierte Reaktionsmischung von Silbernitrat und Polyvinylpyrrolidon zu erhalten;
Waschen der zentrifugierten Reaktionsmischung von Silbernitrat und Polyvinylpyrrolidon mit Ethanol und Aceton, um gereinigte Silbernanopartikel zu erhalten; und
Halten der Silbernanopartikel in Ethanol,
wobei die Kupfernanopartikel in Ethanol durch eine Methode mit folgenden Phasen hergestellt werden:
Auflösen von 37 g Polyvinylpyrrolidon mit Molekularmasse 40000 und 1.1 g Natriumhypophosphat in 100 ml Diäthylenglycol mit magnetischer Rührung während der Erhitzung auf 140°C, um eine Polyvinylpyrrolidonlösung zu erhalten;
Auflösen von1.6 g Kupfersulfat in 10 ml DI-Wasser oder Äthylenglykol, um eine Kupfersulfatlösung zu erhalten;
Einspritzen der Kupfersulfatlösung in die Polyvinylpyrrolidonlösung bei einer kontrollierten Geschwindigkeit von 10 ml/min und Rühren 1 Stunde lang, um eine Reaktionsmischung von Kupfersulfat und Polyvinylpyrrolidon zu erhalten;
Zentrifugieren der Reaktionsmischung von Kupfersulfat und Polyvinylpyrrolidon bei 10000 U/Min, um eine zentrifugierte Reaktionsmischung von Kupfersulfat und Polyvinylpyrrolidon zu erhalten;
Waschen der zentrifugierten Reaktionsmischung von Kupfersulfat und Polyvinylpyrrolidon mit Ethanol und Aceton, um gereinigte Kupfernanopartikel zu erhalten; und
Halten der Kupfernanopartikel in Ethanol.

2. - Tintenformulierung mit:
2.5 ml Äthylenglykol;
2 ml Isopropanol (IPA);
0.5 ml Glycerol;
5 ml Wasser;
0.1 g DISPERBYK-190 und
3.1 g Silbernanopartikel in Ethanol,
wobei die Tintenformulierung einen Feststoffanteil von 3g/10ml hat und die Silbernanopartikel in Ethanol durch eine Methode mit folgenden Phasen hergestellt werden:
Auflösen von 36.4 g Polyvinylpyrrolidon mit Molekularmasse 10000 in 75 ml Äthylenglykol mit magnetischer Rührung während der Erhitzung auf 120°C, um eine Polyvinylpyrrolidonlösung zu erhalten;
Auflösen von 5.8 g Silbernitrat in 25 ml Äthylenglykol, um eine Silbernitratlösung zu erhalten;
Hinzufügen der Silbernitratlösung zur Polyvinylpyrrolidonlösung und Rühren 1 Stunde lang, um eine Reaktionsmischung zu erhalten;
Abkühlung der Reaktionsmischung auf Raumtemperatur;
Zentrifugieren der Reaktionsmischung bei 10000 U/Min, um eine zentrifugierte Reaktionsmischung zu erhalten;
Waschen der zentrifugierten Reaktionsmischung mit Ethanol und Aceton, um gereinigte Silbernanopartikel zu erhalten; und
Halten der Silbernanopartikel in Ethanol.

3. - Tintenformulierung mit:
2.5 ml Äthylenglykol;
2 ml Isopropanol (IPA);
0.5 ml Glycerol;
5 ml Wasser;
0.1 g DISPERBYK-190 und
1.5 g Kupfernanopartikel in Ethanol,
wobei die Tintenformulierung einen Feststoffanteil von 1,5g/10ml hat und die Kupfernanopartikel in Ethanol durch eine Methode mit folgenden Phasen hergestellt werden:
Auflösen von 37 g Polyvinylpyrrolidon mit Molekularmasse 40000 und 1.1 g Natriumhypophosphat in 100 ml Diäthylenglycol mit magnetischer Rührung während der Erhitzung auf 140°C, um eine Polyvinylpyrrolidonlösung zu erhalten;
Auflösen von 1.6 g Kupfersulfat in 10 ml DI-Wasser oder Äthylenglykol, um eine Kupfersulfatlösung zu erhalten;
Einspritzen der Kupfersulfatlösung in die Polyvinylpyrrolidonlösung bei einer kontrollierten Geschwindigkeit von 10 ml/min und Rühren 1 Stunde lang, um eine Reaktionsmischung zu erhalten;
Zentrifugieren der Reaktionsmischung bei 10000 U/Min, um eine zentrifugierte Reaktionsmischung zu erhalten;
Waschen der zentrifugierten Reaktionsmischung mit Ethanol und Aceton, um gereinigte Kupfernanopartikel zu erhalten; und
Halten der Kupfernanopartikel in Ethanol.

4. - Verfahren zur Herstellung einer leitenden Folie, mit:
a. Zubereiten der Tintenformulierung nach Anspruch 1, mit:
1) Vorbereiten der Silbernanopartikel in Ethanol, mit:
Auflösen von 36.4 g Polyvinylpyrrolidon mit Molekularmasse 10000 in 75 ml Äthylenglykol mit magnetischer Rührung während der Erhitzung auf 120°C, um eine Polyvinylpyrrolidonlösung zu erhalten;
Auflösen von 5.8g Silbernitrat in 25ml Äthylenglykol, um eine Silbernitratlösung zu erhalten;
Hinzufügen der Silbernitratlösung zur Polyvinylpyrrolidonlösung und Rühren1 Stunde lang, um eine Reaktionsmischung von Silbernitrat und Polyvinylpyrrolidon zu erhalten;
Abkühlung der Reaktionsmischung auf Raumtemperatur;
Zentrifugieren der Reaktionsmischung von Silbernitrat und Polyvinylpyrrolidon bei 10000 U/Min, um eine zentrifugierte Reaktionsmischung von Silbernitrat und Polyvinylpyrrolidon zu erhalten;
Waschen der zentrifugierten Reaktionsmischung von Silbernitrat und Polyvinylpyrrolidon mit Ethanol und Aceton, um gereinigte Silbernanopartikel zu erhalten;
Halten der Silbernanopartikel in Ethanol;
2) Vorbereiten der Kupfernanopartikel in Ethanol, mit:
Auflösen von 37 g Polyvinylpyrrolidon mit Molekularmasse 40000 und 1.1 g Natriumhypophosphat in 100 ml Diäthylenglycol mit magnetischer Rührung während der Erhitzung auf 140°C, um eine Polyvinylpyrrolidonlösung zu erhalten;
Auflösen von 1.6 g Kupfersulfat in 10 ml DI-Wasser oder Äthylenglykol, um eine Kupfersulfatlösung zu erhalten;
Einspritzen der Kupfersulfatlösung in die Polyvinylpyrrolidonlösung bei einer kontrollierten Geschwindigkeit von 10 ml/min und Rühren 1 Stunde lang, um eine Reaktionsmischung von Kupfersulfat und Polyvinylpyrrolidon zu erhalten;
Zentrifugieren der Reaktionsmischung von Kupfersulfat und Polyvinylpyrrolidon bei 10000 U/Min, um eine zentrifugierte Reaktionsmischung von Kupfersulfat und Polyvinylpyrrolidon zu erhalten;
Waschen der zentrifugierten Reaktionsmischung von Kupfersulfat und Polyvinylpyrrolidon mit Ethanol und Aceton, um gereinigte Kupfernanopartikel zu erhalten;
Halten der Kupfernanopartikel in Ethanol;
3) Mischen von 5ml Wasser, 2.5ml Äthylenglykol, 2ml Isopropanol (IPA), 0.5ml Glycerol, 0.1g DISPERBYK-190, um ein Lösungsgemisch zu erhalten; und
4) Hinzufügen von 1g der Silbernanopartikel in Ethanol und 1.5g der Kupfernanopartikel in Ethanol in das Lösungsgemisch;
5) Dispergieren der Silbernanopartikel in Ethanol und der Kupfernanopartikel in Ethanol im Lösungsgemisch durch mechanische Rührung in einem Ultraschallbad mehr als 3 Stunden lang, um die Tintenformulierung zu erhalten, wobei die Tintenformulierung einen Feststoffanteil von 2,5g/10ml hat;
b. Filtern der Tintenformulierung und Laden der Tintenformulierung in einen Drucker; und
c. Erhalten der leitenden Folie durch Drucken der Tintenformulierung von dem Drucker, um eine Folie zu bilden, und Sintern der Folie bei 150°C 30 min lang.

5. - Verfahren zur Herstellung einer leitenden Folie, mit:
a. Zubereiten der Tintenformulierung nach Anspruch 2, mit:
Auflösen von 36.4g Polyvinylpyrrolidon mit Molekularmasse 10000 in 75ml Äthylenglykol mit magnetischer Rührung während der Erhitzung auf 120°C, um eine Polyvinylpyrrolidonlösung zu erhalten;
Auflösen von 5.8g Silbernitrat in 25ml Äthylenglykol, um eine Silbernitratlösung zu erhalten;
Hinzufügen der Silbernitratlösung zur Polyvinylpyrrolidonlösung und Rühren 1 Stunde lang, um eine Reaktionsmischung zu erhalten;
Abkühlung der Reaktionsmischung auf Raumtemperatur;
Zentrifugieren der Reaktionsmischung bei 10000 U/Min, um eine zentrifugierte Reaktionsmischung zu erhalten;
Waschen der zentrifugierten Reaktionsmischung mit Ethanol und Aceton, um gereinigte Silbernanopartikel zu erhalten;
Halten der Silbernanopartikel in Ethanol;
Mischen von 5ml Wasser, 2.5ml Äthylenglykol, 2ml Isopropanol (IPA), 0.5ml Glycerol, 0.1g DISPERBYK-190, um ein Lösungsgemisch zu erhalten; und
Hinzufügen von 3.1g der Silbernanopartikel in Ethanol zu dem Lösungsgemisch;
Dispergieren der Silbernanopartikel in Ethanol durch mechanische Rührung in einem Ultraschallbad mehr als 3 Stunden lang, um die Tintenformulierung zu erhalten, wobei die Tintenformulierung einen Feststoffanteil von 3g/10ml hat;
b. Filtern der Tintenformulierung und Laden der Tintenformulierung in einen Drucker; und
c. Erhalten der leitenden Folie durch Drucken der Tintenformulierung von dem Drucker, um eine Folie zu bilden, und Sintern der Folie bei 150°C 30 min lang.

6. - Verfahren zur Herstellung einer leitenden Folie, mit:
a. Zubereiten der Tintenformulierung nach Anspruch 3, mit:
Auflösen von 37g Polyvinylpyrrolidon mit Molekularmasse 40000 und 1.1g Natriumhypophosphat in 100ml Diäthylenglycol mit magnetischer Rührung während der Erhitzung auf 140°C, um eine Polyvinylpyrrolidonlösung zu erhalten;
Auflösen von 1.6g Kupfersulfat in 10ml DI-Wasser oder Äthylenglykol, um eine Kupfersulfatlösung zu erhalten;
Einspritzen der Kupfersulfatlösung in die Polyvinylpyrrolidonlösung bei einer kontrollierten Geschwindigkeit von 10 ml/min und Rühren 1 Stunde lang, um eine Reaktionsmischung zu erhalten;
Zentrifugieren der Reaktionsmischung bei 10000 U/Min, um eine zentrifugierte Reaktionsmischung zu erhalten;
Waschen der zentrifugierten Reaktionsmischung mit Ethanol und Aceton, um gereinigte Kupfernanopartikel zu erhalten;
Halten der Kupfernanopartikel in Ethanol;
Mischen von 5ml Wasser, 2.5ml Äthylenglykol, 2ml Isopropanol (IPA), 0.5ml Glycerol, 0.1g DISPERBYK-190, um ein Lösungsgemisch zu erhalten; und
Hinzufügen von 1.5g der Kupfernanopartikel in Ethanol zu dem Lösungsgemisch;
Dispergieren der Kupfernanopartikel in Ethanol durch mechanische Rührung in einem Ultraschallbad mehr als 3 Stunden lang, um die Tintenformulierung zu erhalten, wobei die Tintenformulierung einen Feststoffanteil von 1,5g/10ml hat;
b. Filtern der Tintenformulierung und Laden der Tintenformulierung in einen Drucker;
c. Erhalten der leitenden Folie durch Drucken der Tintenformulierung von dem Drucker, um eine Folie zu bilden, und Sintern der Folie bei 150°C 30 min lang.

7. - Verfahren nach Anspruch 4, 5 oder 6, wobei eine Widerstandsfähigkeit der leitenden Folie weniger als 15 µΩ.cm beträgt.

8. - Verfahren nach den Ansprüchen 4, 5 oder 6, wobei eine Widerstandsfähigkeit der leitenden Folie weniger als 12 µΩ.cm beträgt.

9. - Verfahren nach den Ansprüchen 4, 5 oder 6, wobei eine Stärke der leitenden Folie in einem Bereich von 0,75 µm - 1,0 µm liegt.

10. - Verfahren nach den Ansprüchen 4, 5 oder 6, wobei ein Muster mit einer Größe von 3 mm x 5 mm gedruckt wird, um die leitende Folie zu bilden, wobei eine Korngröße der leitenden Folie 0.5 µm -1.0 µm beträgt, nach dem Sintern bei 150°C, wobei die leitende Folie eine Stärke von 0.75 µm -1.0 µm hat und ein Widerstand der leitenden Folie in einem Bereich von 0.1-0.3 Ohm/sq liegt.

11. - Verfahren nach den Ansprüchen 4, 5 oder 6, wobei die leitende Folie auf ein Substrat gedruckt wird, und das Substrat ist ausgewählt aus einer Gruppe bestehend aus Standardbüropapier, Fotopapier, Polyäthylenterephthalat, Polybutylenterephthalat, Polyethylennaphthalat, Polyimid und Glas.

12. - Verfahren nach den Ansprüchen 4, 5 oder 6, wobei die Sinterung der Folie durch einen Wärmeofen oder eine hochenergetische Blitzlampe erfolgt.

## Revendications

1. - Formulation d'encre comprenant :
2,5 ml d'éthylène glycol ;
2 ml d'isopropanol (IPA) ;
0,5 ml de glycérol ;
5 ml d'eau ;
0,1 g de DISPERBYK-190 ;
1 g de nanoparticules d'argent dans l'éthanol ; et
1,5 g de nanoparticules de cuivre dans l'éthanol,
la formulation d'encre ayant une charge en matières solides de 2,5 g/10 ml, et les nanoparticules d'argent dans l'éthanol étant produites par un procédé qui comprend les étapes consistant à :
dissoudre 36,4 g de polyvinylpyrrolidone ayant une masse moléculaire de 10 000 dans 75 ml d'éthylène glycol avec agitation magnétique alors qu'il est chauffé à 120°C pour obtenir une solution de polyvinylpyrrolidone ;
dissoudre 5,8 g de nitrate d'argent dans 25 ml d'éthylène glycol pour obtenir une solution de nitrate d'argent ;
ajouter la solution de nitrate d'argent dans la solution de polyvinylpyrrolidone et agiter pendant 1 heure pour obtenir un mélange réactionnel de nitrate d'argent et de polyvinylpyrrolidone ;
refroidir le mélange réactionnel de nitrate d'argent et de polyvinylpyrrolidone jusqu'à la température ambiante ;
centrifuger le mélange réactionnel de nitrate d'argent et de polyvinylpyrrolidone à 10 000 tpm pour obtenir un mélange réactionnel centrifugé de nitrate d'argent et de polyvinylpyrrolidone ;
laver le mélange réactionnel centrifugé de nitrate d'argent et de polyvinylpyrrolidone avec de l'éthanol et de l'acétone pour obtenir des nanoparticules d'argent purifiées ; et
conserver les nanoparticules d'argent dans l'éthanol,
les nanoparticules de cuivre dans l'éthanol étant produites par un procédé qui comprend les étapes consistant à :
dissoudre 37 g de polyvinylpyrrolidone ayant une masse moléculaire de 40 000 et 1,1 g d'hypophosphate de sodium dans 100 ml de diéthylène glycol avec agitation magnétique alors qu'il est chauffé à 140°C pour obtenir une solution de polyvinylpyrrolidone ;
dissoudre 1,6 g de sulfate de cuivre dans 10 ml d'eau désionisée ou d'éthylène glycol pour obtenir une solution de sulfate de cuivre ;
injecter la solution de sulfate de cuivre dans la solution de polyvinylpyrrolidone à une vitesse contrôlée de 10 ml/min et agiter pendant 1 heure pour obtenir un mélange réactionnel de sulfate de cuivre et de polyvinylpyrrolidone ;
centrifuger le mélange réactionnel de sulfate de cuivre et de polyvinylpyrrolidone à 10 000 tpm pour obtenir un mélange réactionnel centrifugé de sulfate de cuivre et de polyvinylpyrrolidone ;
laver le mélange réactionnel centrifugé de sulfate de cuivre et de polyvinylpyrrolidone avec de l'éthanol et de l'acétone pour obtenir des nanoparticules de cuivre purifiées ; et
conserver les nanoparticules de cuivre dans l'éthanol.

2. - Formulation d'encre comprenant :
2,5 ml d'éthylène glycol ;
2 ml d'isopropanol (IPA) ;
0,5 ml de glycérol ;
5 ml d'eau ;
0,1 g de DISPERBYK-190 ; et
3,1 g de nanoparticules d'argent dans l'éthanol,
la formulation d'encre ayant une charge en matières solides de 3 g/10 ml ; et les nanoparticules d'argent dans l'éthanol étant produites par un procédé qui comprend les étapes consistant à :
dissoudre 36,4 g de polyvinylpyrrolidone ayant une masse moléculaire de 10 000 dans 75 ml d'éthylène glycol avec agitation magnétique alors qu'il est chauffé à 120°C pour obtenir une solution de polyvinylpyrrolidone ;
dissoudre 5,8 g de nitrate d'argent dans 25 ml d'éthylène glycol pour obtenir une solution de nitrate d'argent ;
ajouter la solution de nitrate d'argent dans la solution de polyvinylpyrrolidone et agiter pendant 1 heure pour obtenir un mélange réactionnel ;
refroidir le mélange réactionnel jusqu'à la température ambiante ;
centrifuger le mélange réactionnel à 10 000 tpm pour obtenir un mélange réactionnel centrifugé ;
laver le mélange réactionnel centrifugé avec de l'éthanol et de l'acétone pour obtenir des nanoparticules d'argent purifiées ; et
conserver les nanoparticules d'argent dans l'éthanol.

3. - Formulation d'encre comprenant :
2,5 ml d'éthylène glycol ;
2 ml d'isopropanol (IPA) ;
0,5 ml de glycérol ;
5 ml d'eau ;
0,1 g de DISPERBYK-190 ; et
1,5 g de nanoparticules de cuivre dans l'éthanol,
la formulation d'encre ayant une charge en matières solides de 1,5 g/10 ml ; et les nanoparticules de cuivre dans l'éthanol étant produites par un procédé qui comprend les étapes consistant à :
dissoudre 37 g de polyvinylpyrrolidone ayant une masse moléculaire de 40 000 et 1,1 g d'hypophosphate de sodium dans 100 ml de diéthylène glycol avec agitation magnétique alors qu'il est chauffé à 140°C pour obtenir une solution de polyvinylpyrrolidone ;
dissoudre 1,6 g de sulfate de cuivre dans 10 ml d'eau désionisée ou d'éthylène glycol pour obtenir une solution de sulfate de cuivre ;
injecter la solution de sulfate de cuivre dans la solution de polyvinylpyrrolidone à une vitesse contrôlée de 10 ml/min et agiter pendant 1 heure pour obtenir un mélange réactionnel ;
centrifuger le mélange réactionnel à 10 000 tpm pour obtenir un mélange réactionnel centrifugé ;
laver le mélange réactionnel centrifugé avec de l'éthanol et de l'acétone pour obtenir des nanoparticules de cuivre purifiées ; et
conserver les nanoparticules de cuivre dans l'éthanol.

4. - Procédé de fabrication d'un film conducteur, comprenant :
a. préparer la formulation d'encre de la revendication 1, comprenant :
1) préparer les nanoparticules d'argent dans l'éthanol, comprenant :
dissoudre 36,4 g de polyvinylpyrrolidone ayant une masse moléculaire de 10 000 dans 75 ml d'éthylène glycol avec agitation magnétique alors qu'il est chauffé à 120°C pour obtenir une solution de polyvinylpyrrolidone ;
dissoudre 5,8 g de nitrate d'argent dans 25 ml d'éthylène glycol pour obtenir une solution de nitrate d'argent ;
ajouter la solution de nitrate d'argent dans la solution de polyvinylpyrrolidone et agiter pendant 1 heure pour obtenir un mélange réactionnel de nitrate d'argent et de polyvinylpyrrolidone ;
refroidir le mélange réactionnel jusqu'à la température ambiante ;
centrifuger le mélange réactionnel de nitrate d'argent et de polyvinylpyrrolidone à 10 000 tpm pour obtenir un mélange réactionnel centrifugé de nitrate d'argent et de polyvinylpyrrolidone ;
laver le mélange réactionnel centrifugé de nitrate d'argent et de polyvinylpyrrolidone avec de l'éthanol et de l'acétone pour obtenir des nanoparticules d'argent purifiées ;
conserver les nanoparticules d'argent dans l'éthanol ;
2) préparer les nanoparticules de cuivre dans l'éthanol, comprenant :
dissoudre 37 g de polyvinylpyrrolidone ayant une masse moléculaire de 40 000 et 1,1 g d'hypophosphate de sodium dans 100 ml de diéthylène glycol avec agitation magnétique alors qu'il est chauffé à 140°C pour obtenir une solution de polyvinylpyrrolidone ;
dissoudre 1,6 g de sulfate de cuivre dans 10 ml d'eau désionisée ou d'éthylène glycol pour obtenir une solution de sulfate de cuivre ;
injecter la solution de sulfate de cuivre dans la solution de polyvinylpyrrolidone à une vitesse contrôlée de 10 ml/min et agiter pendant 1 heure pour obtenir un mélange réactionnel de sulfate de cuivre et de polyvinylpyrrolidone ;
centrifuger le mélange réactionnel de sulfate de cuivre et de polyvinylpyrrolidone à 10 000 tpm pour obtenir un mélange réactionnel centrifugé de sulfate de cuivre et de polyvinylpyrrolidone ;
laver le mélange réactionnel centrifugé de sulfate de cuivre et de polyvinylpyrrolidone avec de l'éthanol et de l'acétone pour obtenir des nanoparticules de cuivre purifiées ;
conserver les nanoparticules de cuivre dans l'éthanol ;
3) mélanger 5 ml d'eau, 2,5 ml d'éthylène glycol, 2 ml d'isopropanol (IPA), 0,5 ml de glycérol, 0,1 g de DISPERBYK-190 pour obtenir un mélange en solution ; et
4) ajouter 1 g des nanoparticules d'argent dans l'éthanol et 1,5 g des nanoparticules de cuivre dans l'éthanol dans le mélange en solution ;
5) disperser les nanoparticules d'argent dans l'éthanol et les nanoparticules de cuivre dans l'éthanol dans le mélange en solution par agitation mécanique dans un bain à ultrasons pendant plus de 3 heures pour obtenir la formulation d'encre, la formulation d'encre ayant une charge en matières solides de 2,5 g/10 ml ;
b. filtrer la formulation d'encre et charger la formulation d'encre dans une imprimante ; et
c. obtenir le film conducteur par impression de la formulation d'encre à partir de l'imprimante pour former un film et fritter le film à 150°C pendant 30 min.

5. - Procédé de fabrication d'un film conducteur, comprenant :
a. préparer la formulation d'encre de la revendication 2, comprenant :
dissoudre 36,4 g de polyvinylpyrrolidone ayant une masse moléculaire de 10 000 dans 75 ml d'éthylène glycol avec agitation magnétique alors qu'il est chauffé à 120°C pour obtenir une solution de polyvinylpyrrolidone ;
dissoudre 5,8 g de nitrate d'argent dans 25 ml d'éthylène glycol pour obtenir une solution de nitrate d'argent ;
ajouter la solution de nitrate d'argent dans la solution de polyvinylpyrrolidone et agiter pendant 1 heure pour obtenir un mélange réactionnel ;
refroidir le mélange réactionnel jusqu'à la température ambiante ;
centrifuger le mélange réactionnel à 10 000 tpm pour obtenir un mélange réactionnel centrifugé ;
laver le mélange réactionnel centrifugé avec de l'éthanol et de l'acétone pour obtenir des nanoparticules d'argent purifiées ;
conserver les nanoparticules d'argent dans l'éthanol ;
mélanger 5 ml d'eau, 2,5 ml d'éthylène glycol, 2 ml d'isopropanol (IPA), 0,5 ml de glycérol, 0,1 g de DISPERBYK-190 pour obtenir un mélange en solution ; et
ajouter 3,1 g des nanoparticules d'argent dans l'éthanol dans le mélange en solution ;
disperser les nanoparticules d'argent dans l'éthanol par agitation mécanique dans un bain à ultrasons pendant plus de 3 heures pour obtenir la formulation d'encre, la formulation d'encre ayant une charge en matières solides de 3 g/10 ml ;
b. filtrer la formulation d'encre et charger la formulation d'encre dans une imprimante ; et
c. obtenir le film conducteur par impression de la formulation d'encre à partir de l'imprimante pour former un film et fritter le film à 150°C pendant 30 min.

6. - Procédé de fabrication d'un film conducteur, comprenant :
a. préparer la formulation d'encre de la revendication 3, comprenant :
dissoudre 37 g de polyvinylpyrrolidone ayant une masse moléculaire de 40 000 et 1,1 g d'hypophosphate de sodium dans 100 ml de diéthylène glycol avec agitation magnétique alors qu'il est chauffé à 140°C pour obtenir une solution de polyvinylpyrrolidone ;
dissoudre 1,6 g de sulfate de cuivre dans 10 ml d'eau désionisée ou d'éthylène glycol pour obtenir une solution de sulfate de cuivre ;
injecter la solution de sulfate de cuivre dans la solution de polyvinylpyrrolidone à une vitesse contrôlée de 10 ml/min et agiter pendant 1 heure pour obtenir un mélange réactionnel ;
centrifuger le mélange réactionnel 10 000 tpm pour obtenir un mélange réactionnel centrifugé ;
laver le mélange réactionnel centrifugé avec de l'éthanol et de l'acétone pour obtenir des nanoparticules de cuivre purifiées ;
conserver les nanoparticules de cuivre dans l'éthanol ;
mélanger 5 ml d'eau, 2,5 ml d'éthylène glycol, 2 ml d'isopropanol (IPA), 0,5 ml de glycérol, 0,1 g de DISPERBYK-190 pour obtenir un mélange en solution ; et
ajouter 1,5 g des nanoparticules de cuivre dans l'éthanol dans le mélange en solution ;
disperser les nanoparticules de cuivre dans l'éthanol par agitation mécanique dans un bain à ultrasons pendant plus de 3 heures pour obtenir la formulation d'encre, la formulation d'encre ayant une charge en matières solides de 1,5 g/10 ml ;
b. filtrer la formulation d'encre et charger la formulation d'encre dans une imprimante ;
c. obtenir le film conducteur par impression de la formulation d'encre à partir de l'imprimante pour former un film et fritter le film à 150°C pendant 30 min.

7. - Procédé selon l'une des revendications 4, 5 ou 6, dans lequel une résistivité du film conducteur est inférieure à 15 µΩ.cm.

8. - Procédé selon l'une des revendications 4, 5 ou 6, dans lequel une résistivité du film conducteur est inférieure à 12 µΩ.cm.

9. - Procédé selon l'une des revendications 4, 5 ou 6, dans lequel une épaisseur du film conducteur se situe dans une plage de 0,75 µm - 1,0 µm.

10. - Procédé selon l'une des revendications 4, 5 ou 6, dans lequel un motif ayant une dimension de 3 mm x 5 mm est imprimé pour former le film conducteur, une dimension de grain du film conducteur est de 0,5 µm - 1,0 µm après frittage à 150°C, le film conducteur a une épaisseur de 0,75 µm - 1,0 µm et une résistance du film conducteur se situe dans une plage de 0,1-0,3 ohm/carré.

11. - Procédé selon l'une des revendications 4, 5 ou 6, dans lequel le film conducteur est imprimé sur un substrat, et le substrat est choisi dans un groupe consistant en papier de bureau standard, papier photographique, poly(téréphtalate d'éthylène), poly(téréphtalate de butylène), poly(naphtalate d'éthylène), polyimide et verre.

12. - Procédé selon l'une des revendications 4, 5 ou 6, dans lequel le frittage du film est effectué par à un four thermique ou une lampe flash à haute énergie.
